# EUROPEAN PATENT SPECIFICATION

(11) **EP 3 324 720 B1**
(45) Date of publication and mention of the grant of the patent: **01.04.2020**
(21) Application number: 15898245.4
(22) Date of filing: 13.07.2015
(51) Int. Cl.: H05K 13/04

(54) **HEAD UNIT OF COMPONENT MOUNTER**
KOPFEINHEIT EINER KOMPONENTENMONTAGEVORRICHTUNG
UNITÉ DE TÊTE DE DISPOSITIF DE MONTAGE DE COMPOSANTS

(43) Date of publication of application: 23.05.2018
(73) Proprietor: FUJI Corporation, Chiryu Aichi (JP)
(72) Inventor: ITO, Hidetoshi, Chiryu Aichi (JP)
(74) Representative: Grünecker Patent- und Rechtsanwälte PartG mbB
(86) International application number: PCT/JP2015/070038
(87) International publication number: WO 2017/009932

(56) References cited:
- EP-A1- 0 637 199
- CN-A- 103 889 163
- JP-A- 2004 225 732
- JP-A- 2011 029 527
- JP-A- 2012 134 258
- JP-A- 2015 099 879
- US-A1- 2006 196 046

## Description

### Technical Field

The present invention relates to a head unit of a component mounter provided with a rotating head (rotary head) on which multiple nozzle holders are provided at a specified interval in a circumferential direction so as to be lowerable.

### Background Art

As disclosed, for example, in patent literature 1 (WO2015/008329), and patent literature 2 (JP-A-2014-183168), there are rotating head (rotary head) type component mounters in which multiple nozzle holders are provided on a rotating head in a lowerable manner at specified intervals in a circumferential direction of the rotating head, a suction nozzle is held pointing downward from each nozzle holder, the rotating head is rotated around an R shaft (vertical shaft) by an R-shaft driving mechanism such that the multiple nozzle holders are revolved in the circumferential direction of the rotating head together with the suction nozzles held by the multiple nozzle holders, and pickup and mounting of a component is performed by lowering a nozzle holder by a Z-shaft driving mechanism at a specified stopping position on the revolving path, and each nozzle holder is rotated around a central axis line by a Q-shaft driving mechanism, such that a direction (angle) of each component held by each suction nozzle held by each nozzle holder is corrected.

In this case, the rotating head is fixed to a lower end section of the R shaft, with both being configured to rotate together, and an R-axis gear is fixed to an upper end section of the R shaft, with a driving gear fixed to a rotation shaft of an R-axis motor engaging with the R-axis gear such that the R shaft is rotated by the R-axis motor, thus rotating the R shaft together with the rotating head.

The documents CN 103 889 163 A and JP 2015 099879 A disclose
further component mounter head units
with a rotating head holding multiple nozzles,
which rotates around a lower end of an R-shaft.

### Citation List

### Patent Literature

Patent literature 1: WO2015/008329
Patent literature 2: JP-A-2014-183168

### Summary of Invention

### Technical Problem

In recent years the speed of component mounting has needed to increase to improve productivity, which has meant that rotating heads need to be rotated at high speed, but with the above configurations, because an upper end of an R shaft is rotated at high speed by an R-axis motor such that a rotating head at a lower end of the R shaft is rotated at high speed, the distance from the R-axis gear at the upper end of the R shaft on which the driving force of the R-axis motor acts to the rotating head on the lower end of the R shaft that is the item being moved, the moment of inertia of the rotation is large, and it is easier for twisting of the R shaft or overshooting of the stopping position of a suction nozzle on the circumference of the rotating head to occur due to the increased speed of the rotating head, which lowers the stopping position accuracy of the suction nozzles on the circumference of the rotating head, leading to a problem of worse component mounting accuracy.

Further, because the R-axis gear is fixed to an upper end of the R axis and the R-axis motor is arranged above that, the size of the head unit including the rotating head and each driving mechanism is large in the vertical direction, which means a large space is required for moving the head unit, leading to a problem of the component mounter Thus, to solve the above problems, an object of the present invention is to improve the positioning accuracy of a suction nozzle on a circumference of a rotating head while enabling high speed rotation of the rotating head, and having a head unit with a smaller overall size in the vertical direction.

### Solution to Problem

The object of the invention is achieved by a component mounter head unit according to claim 1. In particular the present invention includes: a rotating head configured to be rotatable around an R shaft that extends in a vertical direction; multiple nozzle holders provided on the rotating head at specified intervals in a circumferential direction in a lowerable manner, multiple suction nozzles configured to pick up a component, each of the suction nozzles being held pointing downwards on the multiple nozzle holders; an R-axis driving mechanism configured to rotate the rotating head around the R shaft so as to revolve the multiple nozzle holders together with the multiple suction nozzles in the circumferential direction of the rotating head; a Q-axis driving mechanism configured to rotate each of the multiple nozzle holders around its own axis center line so as to correct a direction of each component held by each suction nozzle on each of the nozzle holders; and a Z-axis driving mechanism configured to individually lower the nozzle holders at a specified stopping position on a revolving path of the nozzle holders; wherein the R-axis driving mechanism includes an R-axis gear configured to rotate together with the rotating head around the R shaft, and an R-axis motor configured to rotate a driving gear that engages with the R-axis gear, and the R-axis gear is arranged on a lower surface of the rotating head.

With this configuration, because the R-axis gear that rotates together with the rotating head is provided on a lower surface of the rotating head, compared to a conventional configuration in which the R-axis gear is provided at an upper end of the R shaft, the distance from the R-axis gear on which driving force of the R-axis motor acts to the rotating head is reduced a great deal, such that the moment of inertia of rotation is smaller. By this, it is possible to curtail twisting of the R shaft and overshooting of a stopping position of a suction nozzle on the circumference of the rotating head while enabling faster rotation of the rotating head, thus it is possible to improve the stopping position accuracy of the suction nozzle and thereby improve component mounting accuracy. Further, because the R-axis gear is arranged on the lower surface of the rotating head, the R-axis motor can be arranged at a lower position than conventionally, and the size of the head unit overall in the vertical direction can be made smaller. This means less space is required for movement of the head unit, allowing the component mounter to be made smaller.

With a configuration, where the R shaft is configured to rotate together with the rotating head, the moment of inertia of rotation becomes larger corresponding to the rotation of the R shaft. Thus, in the present invention the configuration is such that the R shaft is fixed to a main body frame of the head unit, and the rotating head is rotatably supported on the R shaft. Accordingly, because it is possible to rotate only the rotating head without rotating the R shaft, the moment of inertia of rotation is reduced by an amount corresponding to the R shaft that does not rotate, thus further improving the positioning accuracy of the suction nozzle.

Also, the R-axis gear may be configured as a scissors gear. Thus, backlash between the R-axis gear and the driving gear is prevented, further improving the positioning accuracy of the suction nozzle.

Note that, a head rotation support section configured to rotatably support an outer circumferential section of the rotating head is provided on the main body frame of the head unit. Accordingly, vibration of the rotating head during rotation is reliably prevented by the head rotation support section, the head rotation support section can be arranged near the R-axis gear on the lower surface of the rotating head, and the engaging of the driving gear and the R-axis gear on the lower surface of the rotating head can be maintained in a stable state even during high speed rotation. With the present invention, the R-axis motor may be arranged to a side of the rotating head, but with this arrangement, the size of the head unit in the width direction is large.

Thus, the R-axis motor may be arranged at a position higher than the rotating head. There is empty space at a position higher than the rotating head, so the R-axis axis motor can be arranged shifted towards the R shaft side, thus allowing the size of the head unit in the width direction to be smaller.

### Brief Description of Drawings

[Fig. 1]

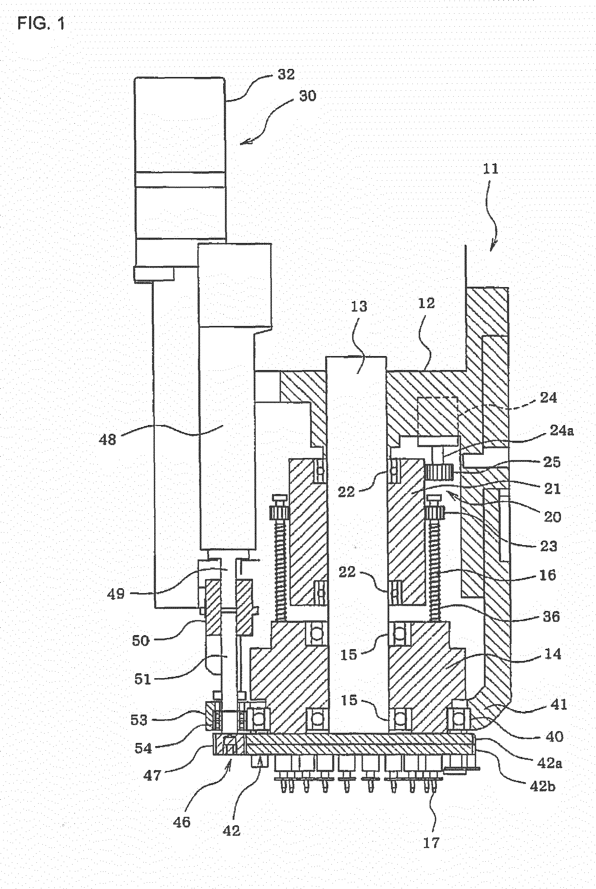

   Fig. 1 is a longitudinal cross section view showing the configuration of a head unit of a component mounter that is an embodiment of the present invention.
[Fig. 2]

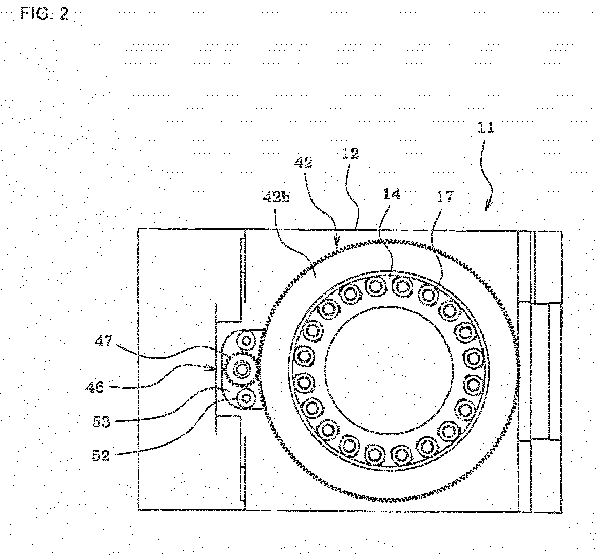

   Fig. 2 is a view from the bottom of the head unit.
[Fig. 3]

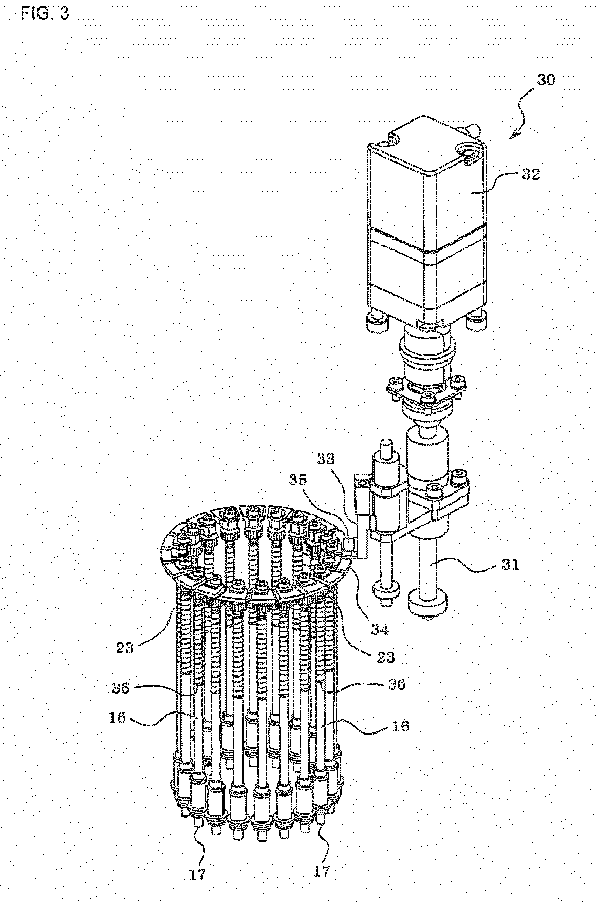

   Fig. 3 is a perspective view showing the positional relationship between the Z-axis driving mechanism and the nozzle holders.
[Fig. 4]

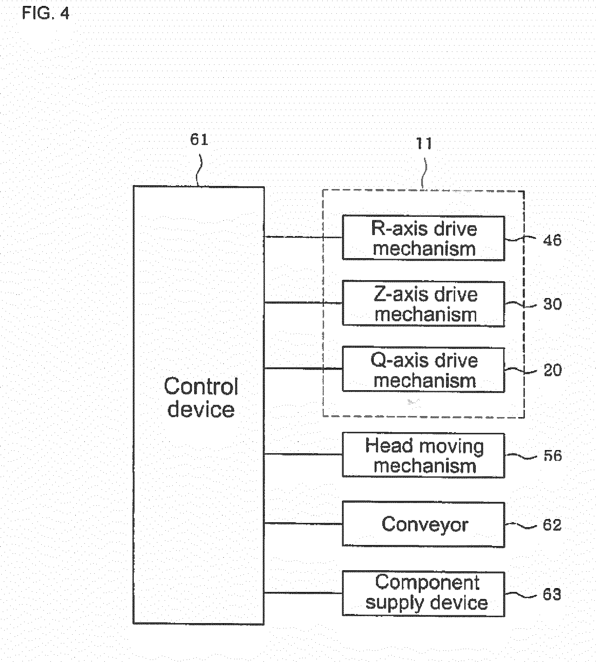

   Fig. 4 is a block diagram showing the configuration of control items of the component mounter.

### Description of Embodiments

An embodiment of the invention is described below. First, the configuration of component mounter head unit 10 is described using figs. 1 to 3.

An upper end of R shaft 13 that extends in the vertical direction is fixedly engaged with main body frame 12 of head unit 11, and rotating head 14 is rotatably supported on a lower section of R shaft 13 via shaft bearing 15. Multiple nozzle holders 16 are lowerably supported on rotating head 14 at specified intervals in a circumferential direction, and suction nozzles 17 that each pick up a component are exchangeably held facing downwards on a lower end section of each nozzle holder 16.

Q-axis gear 21 of Q-axis driving mechanism 20 is rotatably supported on an upper side of rotating head 14 within R shaft 13 via shaft bearing 22. Gears 23 attached to an upper end of each nozzle holder 16 engage with Q-axis gear 21. Gear 25 connected to rotating shaft 24a of Q-axis motor 24 fixed to the main body frame 12 side engages with Q-axis gear 21, and Q-axis gear 21 rotates as one by the rotation of gear 25 of Q-axis motor 24, such that each gear 23 engaged with Q-axis gear 21 rotates, thereby rotating (on own axis) each nozzle holder 16 around a center line axis (Q axis) of each nozzle holder 16, thus enabling the direction (angle) of each component held by each suction nozzle 17 held by each nozzle holder 16 to be corrected. Note that, the Q axis is also referred to as the θ axis.

Further, Z-axis driving mechanism 30 configured to individually lower nozzle holders 16 is provided on head unit 11, and nozzle holders 16 are individually lowered by Z-axis driving mechanism 30 at a specified stopping position on a revolving path of the nozzle holders 16, such that the suction nozzle 17 held by the nozzle holder 16 is lowered. Z-axis driving mechanism 30 may be provided at only one location on the circumference of rotating head 14, or may be provided at two or more locations.

As shown in fig. 3, Z-axis driving mechanism 30 uses Z-axis motor 32 to rotate Z-axis ball screw 31 that is rotatably supported on the main body frame 12 side to move Z-axis slide 33 in a vertical direction, thereby engaging (contacting) engaging member 35 of Z-axis slide 33 into upper end flange 34 of nozzle holder 16 from above, such that nozzle holder 16 moves vertically. In this case, by each nozzle holder 16 being biased upwards by spring 36 (biasing means) attached to each nozzle holder 16, upper end flange 34 of each nozzle holder 16 is supported in a state engaged (contacted) from below by engaging member 35 of Z-axis slide 33, and as engaging member 35 of Z-axis slide 33 is raised, the nozzle holder 16 is raised due to the pushing force of spring 36.

As shown in fig. 1, head rotation support section 41 that rotatably supports a circumferential section of rotating head 14 via shaft bearing 40 is provided on main body frame 12 of head unit 11. Annular R-axis gear 42 is attached to a lower surface of rotating head 14 with R shaft 13 at the center so as to rotate together with rotating head 14. R-axis gear 42 is a scissors gear configured from main gear 42a and sub gear 42b that are overlaid and relatively rotatable, with both gears 42a and 42b being rotationally biased in opposite directions by a spring (not shown).

R-axis driving mechanism 46 that rotates rotating head 14 around R shaft 13 is made from R-axis gear 42 that rotates together with rotating head 14 around R shaft 13, and R-axis motor 48 that rotates driving gear 47 that is engaged with R-axis gear 42, and, as described above, R-axis gear 42 is provided on a lower surface of rotating head 14. As shown in fig. 1, R-axis motor 48 is arranged at a position higher than rotating head 14 with rotating shaft 49 pointing downwards, and a lower end of rotating shaft 49 of R-axis motor 48 is connected via coupling member 50 to shaft 51 that extends upwards from driving gear 47. By this, by driving gear 47 being rotated by R-axis motor 48 such that R-axis gear 42 rotates, rotating head 14 is rotated together with this around R shaft 13, such that the multiple nozzle holders 16 are revolved together with the multiple suction nozzles in the circumferential direction of rotating head 14. Shaft 51 of driving gear 47 is rotataby supported via shaft bearing 54 on shaft support member 53 that is fixed to the main body frame 12 side by screw 52 (refer to fig. 2).

Head unit 11 configured as described above is attached to head moving mechanism 56 (refer to fig. 4) that moves in the XY directions (horizontal directions), and is moved in the XY directions to and from a component pickup area at which component pickup operation is performed and a component mounting area at which component mounting operation is performed.

Control device 61 (refer to fig. 4) of the component mounter controls operation of R-axis driving mechanism 46, Q-axis driving mechanism 20, Z-axis driving mechanism 30, head moving mechanism 56, and conveyor 62 that conveys circuit boards, so as to move head unit 11 to the component pickup area, pick up a component supplied from component supply device 63 using suction nozzle 17, move head unit 11 to the component mounting area, and mount the component on a circuit board.

With the embodiment described above, because R-axis gear 42 that rotates together with rotating head 14 is provided on a lower surface of rotating head 14, compared to a conventional configuration in which the R-axis gear is provided at an upper end of the R shaft, the distance from R-axis gear 42 on which driving force of R-axis motor 48 acts to rotating head 14 is reduced a great deal, such that the moment of inertia of rotation is smaller. By this, it is possible to curtail overshooting of a stopping position of suction nozzle 17 on the circumference of rotating head 14 while enabling faster rotation of rotating head 14, thus it is possible to improve the stopping position accuracy of suction nozzle 17 and thereby improve component mounting accuracy. Further, because R-axis gear 42 is arranged on the lower surface of rotating head 14, R-axis motor 48 can be arranged at a lower position than conventionally, and the size of head unit 11 overall in the vertical direction can be made smaller. This means less space is required for movement of head unit 11, allowing the component mounter to be made smaller. Also, because the load (moment of inertia of rotation) on R-axis motor 48 is reduced, R-axis motor 48 can be made smaller, reducing the energy required.

Further, with the present embodiment, because R shaft 13 is fixed to main body frame 12 of head unit 11, and rotating head 14 is rotatably supported on R shaft 13, only rotating head 14 can be rotated, without needing to rotate R shaft 13. Thus, the moment of inertia of rotation can be reduced by the amount of R shaft 13 that does not rotate, meaning that positioning accuracy of rotating head 14 does not deteriorate due to twisting of R shaft 13, and positioning accuracy of suction nozzles 17 on the circumference of rotating head 14 is improved further.

However, with the present invention, R shaft 13 may be configured to rotate together with rotating head 14, and even in this case it is possible to realize an object of the invention.

Also, with the present invention, because head rotation support section 41 that rotatably supports a circumferential section of rotating head 14 is provided on main body frame 12 of head unit 11, vibration of rotating head 14 during rotation is reliably prevented by head rotation support section 41, and by providing head rotation support section 41 near to R-axis gear 42 on a lower surface of rotating head 14, the engaging of driving gear 47 and R-axis gear 13 on the lower surface of rotating head 14 can be maintained in a stable state even during high speed rotation of rotating head 14.

Also, because R-axis motor 48 is provided at a position higher than rotating head 14, using empty space above rotating head 14, R-axis motor 48 can be arranged shifted towards the R shaft 13 side, thus allowing the size of head unit 11 in the width direction to be smaller.

Note that, the present invention is not limited to the above embodiment and it goes without saying that various embodiments with changes that do not extend beyond the scope of the invention are possible, such as that suitable changes may be made to the configuration of Q-axis driving mechanism 20 and Z-axis driving mechanism 30, or to the quantity of nozzle holders 16 (suction nozzles 17).

### Reference Signs List

11: head unit; 12: main body frame; 13: R shaft; 14: rotating head; 15: shaft bearing; 16: nozzle holder; 17: suction nozzle; 20: Q-axis driving mechanism; 21: Q-axis gear; 22: shaft bearing; 24: Q-axis motor; 30: Z-axis driving mechanism; 40: shaft bearing; 41: head rotation support section; 42: R-axis gear; 47: drive gear; 48: R-axis motor; 56: head moving mechanism

## Claims

1. A component mounter head unit (11) comprising:
a rotating head (14) configured to be rotatable around an R shaft (13) that extends in a vertical direction;
multiple nozzle holders (16) provided on the rotating head (14) at specified intervals in a circumferential direction in a lowerable manner;
multiple suction nozzles (17) configured to pick up a component, each of the suction nozzles (17) being held pointing downwards on the multiple nozzle holders (16);
an R-axis driving mechanism (46) configured to rotate the rotating head (14) around the R shaft (13) so as to revolve the multiple nozzle holders (16) together with the multiple suction nozzles (17) in the circumferential direction of the rotating head (14);
a Q-axis driving mechanism (20) configured to rotate each of the multiple nozzle holders (16) around its own axis center line so as to correct a direction of each component held by each suction nozzle (17) on each of the nozzle holders (16); and
a Z-axis driving mechanism (30) configured to individually lower the nozzle holders (16) at a specified stopping position on a revolving path of the nozzle holders (16);
wherein
the R-axis driving mechanism (46) includes an R-axis gear (42) configured to rotate together with the rotating head (14) around the R shaft (13), and an R-axis motor (48) configured to rotate a driving gear (47) that engages with the R-axis gear (42), and
the R-axis gear (42) is arranged on a lower surface of the rotating head (14), **characterized by**
the R shaft (13) is fixed to a main body frame (12) of the head unit (11), and
the rotating head (14) is rotatably supported on the R-shaft (13) and
a head rotation support (41) section configured to rotatably support an outer circumferential section of the rotating head (14) is provided on the main body frame (12) of the head unit (11).

2. The component mounter head unit (11) according to claim 1, wherein
the R-axis gear (42) is configured using a scissors gear.

3. The component mounter head unit (11) according to claim 1 or 2, wherein
a rotating shaft of the R-axis motor (48) points downwards and is connected to the driving gear (47), and the R-axis motor (48) is provided at a position higher than the rotating head (14).

## Patentansprüche

1. Eine Kopfeinheit einer Komponentenmontagevorrichtung (11) umfassend:
einen Rotationskopf (14), der konfiguriert ist, um eine R-Welle (13) drehbar zu sein, die sich in einer vertikalen Richtung erstreckt;
mehrere Düsenhalter (16), die in festgelegten Abständen in Umfangsrichtung am Rotationskopf (14) in absenkbarer Weise vorgesehen sind;
mehrere Saugdüsen (17) zum Aufnehmen einer Komponente, wobei jede der Saugdüsen (17) auf den mehreren Düsenhaltern (16) nach unten gerichtet gehalten ist;
einen R-Achsen-Antriebsmechanismus (46), der konfiguriert ist, um den Rotationskopf (14) um die R-Welle (13) zu drehen, um die mehreren Düsenhalter (16) zusammen mit den mehreren Saugdüsen (17) in der Umfangsrichtung des Rotationskopf (14) zu drehen;
einen Q-Achsen-Antriebsmechanismus (20), der konfiguriert ist, um jeden der mehreren Düsenhalter (16) um seine eigene Achsenmittellinie zu drehen, um eine Richtung jeder Komponente zu korrigieren, die von jeder Saugdüse (17) an jedem der Düsenhalter (16) gehalten wird; und
einen Z-Achsen-Antriebsmechanismus (30), der so konfiguriert ist, dass er die Düsenhalter (16) an einer bestimmten Halteposition auf einem Rotationsweg der Düsenhalter (16) einzeln absenkt; wobei
der R-Achsen-Antriebsmechanismus (46) ein R-Achsen-Zahnrad (42) umfasst, das so konfiguriert ist, dass es sich zusammen mit dem Rotationskopf (14) um die R-Welle (13) dreht, und einen R-Achsen-Motor (48), der so konfiguriert ist, dass er ein Antriebszahnrad (47) dreht, das in das R-Achsen-Zahnrad (42) eingreift, und
das R-Achsen-Zahnrad (42) an einer unteren Fläche des Drehkopfes (14) angeordnet ist, gekennzeichnet darin dass
die R-Welle (13) an einem Hauptkörperrahmen (12) der Kopfeinheit (11) befestigt ist, und
der Rotationskopf (14) drehbar auf der R-Welle (13) gelagert ist und
ein Kopfrotationsstützabschnitt (41), der konfiguriert ist, um einen Außenumfangsabschnitt des Rotationskopfs (14) drehbar zu stützen, an dem Hauptkörperrahmen (12) der Kopfeinheit (11) angeordnet ist.

2. Die Kopfeinheit einer Komponentenmontagevorrichtung (11) gemäß Anspruch 1, wobei das R-Achsen-Zahnrad (42) konfiguriert ist ein Scherengetriebes zu verwenden.

3. Die Kopfeinheit einer Komponentenmontagevorrichtung (11) gemäß Anspruch 1 oder 2, wobei
eine Drehwelle des R-Achsenmotors (48) nach unten zeigt und mit dem Antriebszahnrad (47) verbunden ist, und der R-Achsenmotor (48) an einer Position höher als der Rotationskopfs (14) angeordnet ist.

## Revendications

1. Unité formant tête de dispositif de montage de composants (11) comprenant :
une tête tournante (14) configurée pour pouvoir tourner autour d'un axe R (13) qui s'étend dans la direction verticale,
de multiples supports de buses (16) disposés sur la tête tournante (14) à des intervalles spécifiés dans la direction circonférentielle de façon à pouvoir s'abaisser,
de multiples buses d'aspiration (17) configurées pour prélever un composant, chacune des buses d'aspiration (17) étant maintenue la tête vers le bas sur les multiples supports de buses (16),
un mécanisme d'entraînement d'axe R (46) configuré pour faire tourner la tête tournante (14) autour de l'axe R (13) de sorte à faire tourner les multiples supports de buses (16) en même temps que les multiples buses d'aspiration (17) dans la direction circonférentielle de la tête tournante (14),
un mécanisme d'entraînement d'axe Q (20) configuré pour faire tourner chacun des multiples supports de buses (16) autour de son propre axe central de sorte à corriger la direction de chaque composant maintenu par chaque buse d'aspiration (17) sur chacun des supports de buses (16), et
un mécanisme d'entraînement d'axe Z (30) configuré pour abaisser individuellement les supports de buses (16) à une position spécifiée d'arrêt sur le trajet de révolution des supports de buses (16),
dans lequel
le mécanisme d'entraînement d'axe R (46) inclut un engrenage d'axe R (42) configuré pour tourner en même temps que la tête tournante (14) autour de l'axe R (13), ainsi qu'un moteur d'axe R (48) configuré pour faire tourner l'engrenage d'entraînement (47) qui se met en prise avec l'engrenage d'axe R (42), et
l'engrenage d'axe R (42) est disposé sur la surface inférieure de la tête tournante (14),
**caractérisé par**
l'axe R (13) est fixé sur un châssis de corps principal (12) de l'unité formant tête (11), et
la tête tournante (14) est supportée tout en pouvant tourner sur l'axe R (13), et
une section de support de rotation de tête (41), configurée pour supporter avec une possibilité de rotation la section circonférentielle externe de la tête tournante (14), est disposée sur le châssis de corps principal (12) de l'unité formant tête (11).

2. Unité formant tête de dispositif de montage de composants (11) selon la revendication 1, dans laquelle :
l'engrenage d'axe R (42) est configuré en utilisant un engrenage en ciseaux.

3. Unité formant tête de dispositif de montage de composants (11) selon la revendication 1 ou la revendication 2, dans laquelle :
l'axe de rotation du moteur d'axe R (48) pointe vers le bas et il est relié à l'engrenage d'entraînement (47), et le moteur d'axe R (48) est disposé sur une position plus haute que celle de la tête tournante (14).
